# EUROPEAN PATENT APPLICATION

(11) **EP 4 746 601 A1**
(43) Date of publication of application: **20.05.2026**
(21) Application number: 25760918.0
(22) Date of filing: 26.02.2025
(51) Int. Cl.: H05K 5/02

(54) **ELECTRONIC APPARATUS AND TERMINAL DEVICE**

(30) Priority: 29.02.2024 CN 202410232259
(71) Applicant: Shenzhen Yinwang Intelligent Technologies Co., Ltd., Shenzhen, Guangdong 518110 (CN)
(72) Inventor: LEI, Yi, Shenzhen, Guangdong 518129 (CN); HU, Zhenming, Shenzhen, Guangdong 518129 (CN); CUI, Peihua, Shenzhen, Guangdong 518129 (CN); GUAN, Qihui, Shenzhen, Guangdong 518129 (CN)
(74) Representative: MERH-IP Matias Erny Reichl Hoffmann Patentanwälte PartG mbB
(86) International application number: PCT/CN2025/079156
(87) International publication number: WO 2025/180378

(57) **Abstract**

An electronic apparatus and a terminal device are disclosed. The electronic apparatus includes a first housing, an intermediate component, and a second housing. The first housing is fastened to the second housing. The intermediate component is fastened in a cavity formed by the first housing and the second housing. The first housing includes an outer surface and an inner surface, the inner surface is a side surface facing the intermediate component, and the outer surface is another side surface facing away from the inner surface. A first ventilation channel is disposed on the outer surface of the first housing, the first housing is provided with a first through hole, a second ventilation channel is disposed in the cavity, and the first through hole communicates with the first ventilation channel and the second ventilation channel. According to this solution, a ventilation function of the electronic apparatus can be implemented at low costs while introduction of external water vapor is reduced.

## Description

This application claims priority to Chinese Patent Application No. 202410232259.2, filed with the China National Intellectual Property Administration on February 29, 2024, and entitled "ELECTRONIC APPARATUS AND TERMINAL DEVICE", which is incorporated herein by reference in its entirety.

### TECHNICAL FIELD

This application relates to the field of electronic technologies, and specifically, to an electronic apparatus and a terminal device.

### BACKGROUND

A large quantity of electronic apparatuses each include a housing. The housing can be configured to accommodate, fasten, mount, and protect various components in the electronic apparatus, and can further serve an aesthetic function and provide various shapes, and the like. However, if the housing is sealed and airtight, the following risks may occur: 1. In a prolonged high-humidity environment, diffusion of water molecules tends to cause internal condensation, leading to long-term accumulation. 2. The sealed design is not conducive to volatilization of organic molecules and aggravates corrosion of components in an inner cavity. 3. When pressure differential persists inside the electronic apparatus or leakage occurs at a weak point due to a breathing effect, presence of negative pressure may lead to backflow of water into the apparatus. Therefore, it is important to design a ventilation structure to maintain air pressure balance between the inside and outside of the electronic apparatus.

In some current ventilation design solutions, a waterproof ventilation valve is disposed on the housing of the electronic apparatus through snap-fitting or thread-fastening, to keep the electronic apparatus ventilated. Alternatively, a ventilation structure is formed by providing an air hole on the housing and then attaching a waterproof ventilation film to the air hole. Alternatively, a hollow-out structure is disposed on the housing to achieve internal and external ventilation balance. However, in some of these design solutions, an additional ventilation valve or ventilation film needs to be added. Consequently, mounting is complex and costs are increased. In some designs, a hollow-out structure is used for ventilation. The hollow-out design has high costs and a large ventilation amount, and external water vapor is easily introduced into the electronic apparatus, leading to formation of more condensation beads. Therefore, how to implement a ventilation function of the electronic apparatus at low costs while reducing introduction of external water vapor is a technical problem that urgently needs to be resolved.

### SUMMARY

This application provides an electronic apparatus and a terminal device, to implement a ventilation function of the electronic apparatus at low costs while reducing introduction of external water vapor.

According to a first aspect, this application provides an electronic apparatus. The electronic apparatus includes a first housing, an intermediate component, and a second housing, the first housing is fastened to the second housing, and the intermediate component is fastened in a cavity formed by the first housing and the second housing.

The first housing includes an outer surface and an inner surface, the inner surface is a side surface facing the intermediate component, and the outer surface is another side surface facing away from the inner surface.

A first ventilation channel is disposed on the outer surface of the first housing, the first housing is provided with a first through hole, a second ventilation channel is disposed in the cavity, and the first through hole communicates with the first ventilation channel and the second ventilation channel.

For example, the first housing and the second housing can be fastened through any one of the following connections: a threaded connection, a snap-fit connection, an adhesive connection, an ultrasonic connection, a solder connection, a hinged connection, a rivet connection, or the like.

For example, one or more first ventilation channels can be disposed on the outer surface of the first housing, and one or more second ventilation channels can be disposed in the cavity. This can be selected based on a ventilation rate requirement.

In this solution, ventilation channels are disposed on an outer surface of a housing of the electronic apparatus and in a cavity between housings, and a through hole on the housing communicates with the ventilation channels inside and outside the housing, to implement internal and external ventilation of the housing and maintain internal and external pressure balance. In this solution, the ventilation channel is directly formed on the housing, and no additional ventilation valve or ventilation film is required. This reduces mounting and inspection steps of the ventilation valve or ventilation film, and greatly reduces costs. In addition, in this solution, gas needs to pass through two ventilation channels and one through hole, and a gas flow path is long, so that a ventilation rate is controllable, and introduction of external water vapor is reduced.

In a possible implementation, the second ventilation channel is angularly deflected relative to the first ventilation channel.

In this solution, there is an angular deflection between an internal ventilation channel and an external ventilation channel, so that a length and tortuosity of a gas flow path can be increased, a ventilation amount can be reduced, and introduction of external water vapor can be further reduced.

In a possible implementation, if the first housing and the second housing are fastened through a threaded connection, the first through hole is a through hole through which a threaded joint penetrates.

In this solution, if a housing is fastened through a threaded connection, the through hole of the threaded joint can be reused as a through hole that communicates with the internal ventilation channel and the external ventilation channel, to reduce costs and overheads of additionally disposing the through hole.

In a possible implementation, the first ventilation channel extends beyond an area covered by a head of the threaded joint.

In this solution, the ventilation channel on the outer surface is designed to extend beyond the area covered by the head of the threaded joint, to facilitate circulation of internal and external gas. In addition, the length of the gas flow path is increased, so that the ventilation rate is controllable, and introduction of external water vapor is reduced.

In a possible implementation, an inner surface of the second housing is provided with a threaded hole, the threaded hole is configured to fit the threaded joint to fasten the first housing and the second housing, and the inner surface of the second housing is a side surface facing the intermediate component; and the second ventilation channel is disposed on an end face of the threaded hole.

In this solution, the internal ventilation channel is disposed on the end face of the threaded hole, so that the length and tortuosity of the internal and external gas flow path can be increased, the gas flows tortuously in the path, the ventilation amount is reduced, and introduction of external water vapor is reduced.

In a possible implementation, the second ventilation channel is disposed on the inner surface of the first housing.

In this solution, the internal ventilation channel is disposed on the inner surface of the housing on which the external ventilation channel is disposed, so that the gas can pass through the first through hole and enter the interior.

In a possible implementation, the intermediate component includes a second through hole, and the threaded joint penetrates through the second through hole.

In this solution, the threaded joint that fastens the upper and lower housings also penetrates through the intermediate component, and is used to fasten the intermediate component. This can enhance stability of the intermediate component.

In a possible implementation, the electronic apparatus further includes a sealing element, the sealing element is disposed between the first housing and the second housing, the first through hole is in the middle of the sealing element, and the second ventilation channel extends beyond a coverage area of the sealing ring.

In this solution, air tightness of the electronic apparatus can be increased through the sealing element. In this scenario, a length of the second ventilation channel can be extended beyond the coverage area of the sealing element, so that the controllable ventilation rate can be maintained.

In a possible implementation, cross sections of the first ventilation channel and the second ventilation channel are rectangular, triangular, semicircular, or the like.

In this solution, a shape of a cross section of a ventilation channel is not limited, so that implementation is flexible and applicable to various scenarios.

In a possible implementation, the first ventilation channel and the second ventilation channel are straight channels or curved channels.

In this solution, a line type of the ventilation channel is not limited, so that implementation is flexible and applicable to various scenarios.

In a possible implementation, the electronic apparatus further includes a cooling medium inlet and a third through hole, a cooling medium is used for dissipating heat for the electronic apparatus, and no ventilation channel that communicates with the third through hole is disposed. The first through hole is closer to the cooling medium inlet than the third through hole.

In this solution, a ventilation channel is disposed close to the cooling medium inlet. Because a temperature at this position is the lowest and condensation beads are most likely to be formed, the ventilation channel can be designed here to quickly dissipate condensation beads.

In a possible implementation, the electronic apparatus further includes a moisture absorption module and a fourth through hole, the moisture absorption module is configured to absorb water vapor inside the electronic apparatus, and no ventilation channel that communicates with the fourth through hole is disposed. The first through hole is closer to the moisture absorption module than the fourth through hole.

In this solution, the ventilation channel is disposed close to the moisture absorption module. The ventilation channel is disposed nearby to quickly evaporate the water vapor absorbed by the moisture absorption module.

In a possible implementation, the electronic apparatus is an autonomous driving controller, a cockpit domain controller, a vehicle control unit, or a vehicle integrated/integration unit in a vehicle.

In this solution, the electronic apparatus can be various controllers or a component including a housing in the vehicle. Optionally, the electronic apparatus can alternatively be, for example, various intelligent terminal devices, industrial devices, or entertainment devices that include a housing.

According to a second aspect, this application provides a terminal device. The terminal device includes the electronic apparatus according to any one of the first aspect.

For example, the terminal device can be a transportation means like a vehicle, an unmanned aerial vehicle, or a robot. Certainly, the terminal device can alternatively be replaced with an industrial device, an entertainment device, or the like.

### BRIEF DESCRIPTION OF DRAWINGS

FIG. 1 is a diagram of an appearance of an electronic apparatus according to an embodiment of this application;
FIG. 2 and FIG. 3 are diagrams of an exploded structure of an electronic apparatus according to an embodiment of this application;
FIG. 4 to FIG. 6 are partial cross-sectional diagrams of a through hole according to an embodiment of this application;
FIG. 7 and FIG. 8 are diagrams of a line type of a ventilation channel according to an embodiment of this application;
FIG. 9 and FIG. 10 are diagrams of an exploded structure of an electronic apparatus according to an embodiment of this application;
FIG. 11 to FIG. 13 are partial cross-sectional diagrams of an electronic apparatus according to an embodiment of this application;
FIG. 14 is a diagram of a ventilation channel on an end face of a threaded hole according to an embodiment of this application;
FIG. 15 is a partial top view of an outer surface of a first housing;
FIG. 16 is a partial cross-sectional diagram of an electronic apparatus according to an embodiment of this application;
FIG. 17 is a partial diagram of an inner surface of a first housing; and
FIG. 18 and FIG. 19 are diagrams of an appearance structure of an electronic apparatus viewed from the top of the first housing.

### DESCRIPTION OF EMBODIMENTS

In embodiments of this application, "a plurality of" means two or more than two. In embodiments of this application, "and/or" is used to describe an association relationship between associated objects, and represents three relationships that can exist independently. For example, A and/or B can represent the following: Only A exists, only B exists, or both A and B exist. A description, for example, "at least one (or at least one piece) of a1, a2, ..., and an", used in embodiments of this application includes a case in which any one of a1, a2, ..., and an exists alone, and also includes any combination of any plurality of a1, a2, ..., and an. Each case can exist alone. For example, a description of "at least one of a, b, and c" includes a case of a single a, a single b, a single c, a combination of a and b, a combination of a and c, a combination of b and c, or a combination of a, b, and c.

Terms such as "first" and "second" in this application are used to distinguish between same or similar items with basically same roles and functions. It should be understood that there is no logical or timing dependency between "first", "second", and "n^{th}", and neither a quantity nor an execution sequence is limited. It should also be understood that although the following descriptions use terms such as "first" and "second" to describe various elements, these elements should not be limited by the terms. These terms are simply used to distinguish one element from another element.

In various embodiments of this application, unless otherwise stated or there is a logic conflict, terms and/or descriptions in embodiments are consistent and can be mutually referenced, and technical features in different embodiments can be combined based on an internal logical relationship thereof, to form a new embodiment.

Embodiments of this application provide an electronic apparatus to implement a ventilation function of the electronic apparatus at low costs while reducing introduction of external water vapor. The electronic apparatus includes a first housing, an intermediate component, and a second housing. The first housing is fastened to the second housing. The intermediate component is fastened in a cavity formed by the first housing and the second housing. The first housing includes an outer surface and an inner surface, the inner surface is a side surface facing the cavity, and the outer surface is another side surface facing away from the inner surface. A first ventilation channel is disposed on the outer surface of the first housing. In addition, the first housing is provided with a first through hole. In addition, a second ventilation channel is disposed in the cavity formed by the first housing and the second housing. The first through hole can communicate with the first ventilation channel and the second ventilation channel. The following provides example descriptions with reference to the accompanying drawings.

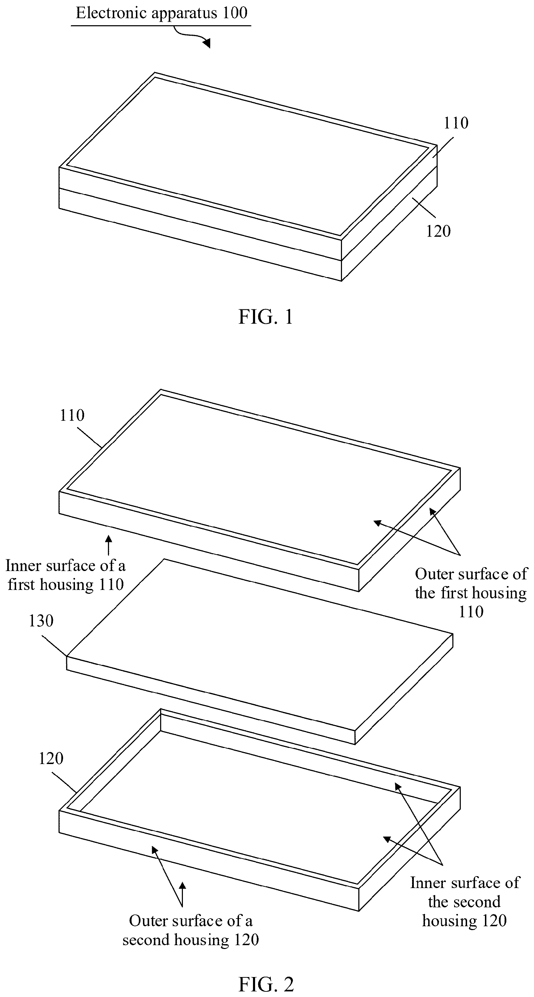

For example, FIG. 1 is a diagram of an appearance of an electronic apparatus 100 according to an embodiment of this application. It can be learned that the electronic apparatus 100 can include a first housing 110 and a second housing 120. The first housing 110 is fastened to the second housing 120. For example, the first housing 110 and the second housing 120 can be fastened through any one of the following connections: a threaded connection, a snap-fit connection, an adhesive connection, an ultrasonic connection, a solder connection, a hinged connection, a rivet connection, or the like. The threaded connection is a detachable connection in which connected parts are connected as a whole by using a threaded joint. Common threaded joints include bolts, studs, screws, and the like. It can be understood that the descriptions of the connections herein are merely an example, and do not constitute a limitation on embodiments of this application.

For example, the electronic apparatus 100 can be a vehicle-mounted module device, an intelligent terminal device, an industrial device, an entertainment device, or the like. The vehicle-mounted module device includes but is not limited to a mobile data center (mobile data center, MDC) device (for example, also referred to as an autonomous driving controller), a cockpit domain controller (cockpit domain controller, CDC), a vehicle control unit (vehicle control unit, VCU), a vehicle integrated/integration unit (vehicle integrated/integration unit, VIU), a telematics box (telematics BOX, T-BOX), or the like. The intelligent terminal device includes but is not limited to a mobile phone, a tablet computer, a notebook computer, a smart band, a smart watch, smart glasses, or the like. The industrial device includes but is not limited to an industrial robot, a mechanical arm, or the like. The entertainment device includes but is not limited to a virtual reality (virtual reality, VR) device, a mixed reality (mixed reality, MR) device, a massage chair, a 4D cinema cabin, or the like. It can be understood that the descriptions of the electronic apparatus 100 herein are merely an example, and do not constitute a limitation on embodiments of this application. During specific implementation, a device or an apparatus that includes a housing and has a ventilation requirement can be the electronic apparatus 100 in this embodiment of this application.

For example, the electronic apparatus 100 further includes an intermediate component 130. For ease of understanding, refer to a diagram of an exploded structure of the electronic apparatus 100 shown in FIG. 2 as an example. It can be learned that the intermediate component 130 is located between the first housing 110 and the second housing 120. For example, the intermediate component 130 is fastened in a cavity formed by the first housing 110 and the second housing 120.

For example, the intermediate component 130 can include a printed circuit board (printed circuit board, PCB), a PCB component, or the like. This is not limited in embodiments of this application.

For example, it can be further learned from FIG. 2 that the first housing 110 includes an inner surface and an outer surface. The inner surface of the first housing 110 is a side surface facing the intermediate component 130. The outer surface of the first housing 110 is another side surface facing away from the inner surface of the first housing 110. Similarly, the second housing 120 includes an inner surface and an outer surface. The inner surface of the second housing 120 is a side surface facing the intermediate component 130. The outer surface of the second housing 120 is another side surface facing away from the inner surface of the second housing 120.

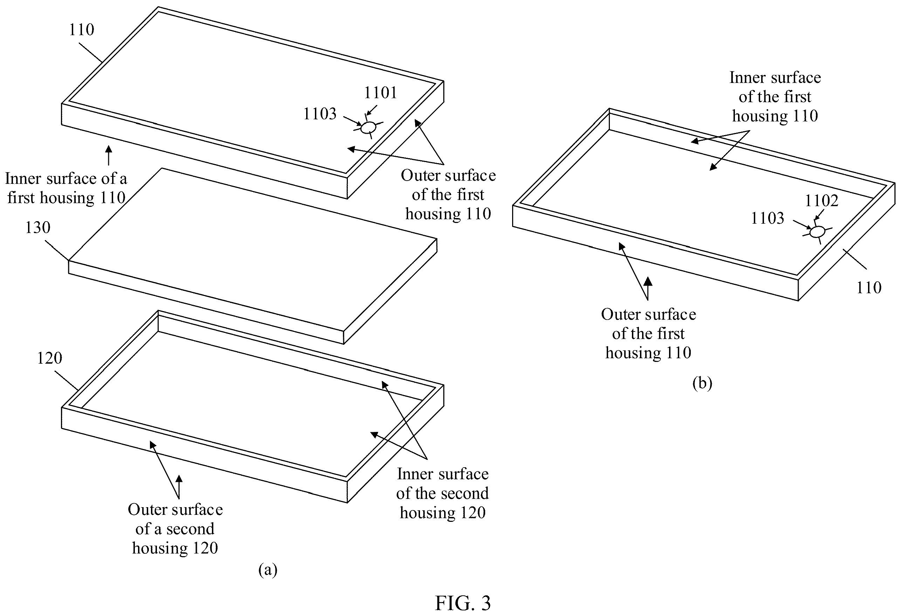

For example, refer to FIG. 3. As shown in (a) in FIG. 3, a first ventilation channel 1101 is disposed on the outer surface of the first housing 110. As shown in (b) in FIG. 3, a second ventilation channel 1102 is disposed on the inner surface of the first housing 110. In addition, the first housing 110 is further provided with a first through hole 1103. The first through hole 1103 communicates with the first ventilation channel 1101 and the second ventilation channel 1102.

For example, during specific implementation, the first housing 110 can be provided with one or more first through holes 1103. FIG. 3 shows one first through hole 1103 as an example. In addition, each first through hole 1103 can communicate with one or more first ventilation channels 1101, and each first through hole 1103 can communicate with one or more second ventilation channels 1102. FIG. 3 mainly shows an example in which one first through hole 1103 communicates with four first ventilation channels 1101 and four second ventilation channels 1102.

It can be understood that the foregoing mainly uses an example in which the first ventilation channel is disposed on the first housing 110. In another implementation, the first ventilation channel can be disposed on the second housing 120. Details are not described herein.

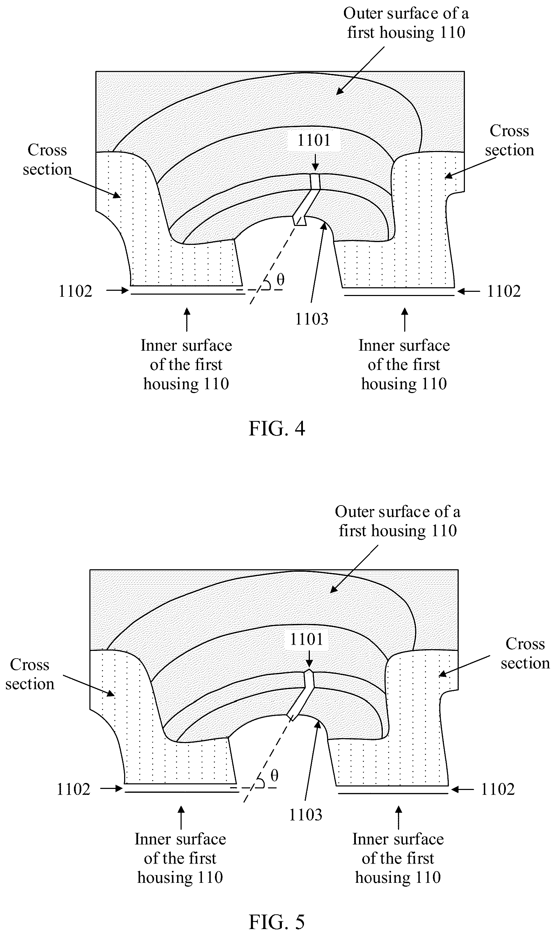

In a possible implementation, the second ventilation channel 1102 is angularly deflected relative to the first ventilation channel 1101. For ease of understanding, refer to FIG. 4 as an example. FIG. 4 is a partial cross-sectional diagram of the first through hole 1103 included in the first housing 110. It can be learned that there is an angular deflection of θ between the first ventilation channel 1101 located on the outer surface of the first housing 110 and the second ventilation channel 1102 located on the inner surface of the first housing 110. For example, the deflection angle can be greater than 0° and less than 180°. A specific deflection angle is not limited in embodiments of this application.

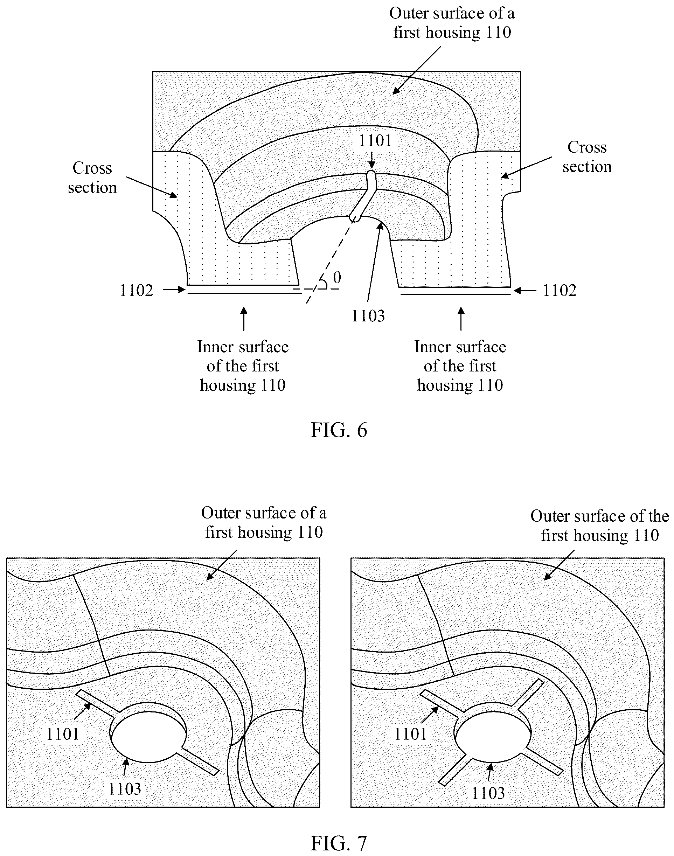

In a possible implementation, cross sections of the first ventilation channel 1101 and the second ventilation channel 1102 are in any planar geometric shape like a rectangle, a triangle, a semicircle, a rhombus, a trapezoid, or a pentagon. For example, refer to FIG. 4. Cross sections of the first ventilation channel 1101 and the second ventilation channel 1102 shown in FIG. 4 are rectangular. For another example, refer to FIG. 5 and FIG. 6. Cross sections of the first ventilation channel 1101 and the second ventilation channel 1102 shown in FIG. 5 are triangular. Cross sections of the first ventilation channel 1101 and the second ventilation channel 1102 shown in FIG. 5 are semicircular. It can be understood that the descriptions of shapes of the cross sections of the first ventilation channel 1101 and the second ventilation channel 1102 herein are merely examples, and do not constitute a limitation on embodiments of this application.

For example, as shown in FIG. 4 to FIG. 6, the outer surface of the first housing 110 can be uneven. For example, in FIG. 4 to FIG. 6, a circular recessed area and some lines can be disposed at a position of the first through hole 1103. Similarly, the inner surface of the first housing 110 can also be uneven. Specifically, a related shape can be designed as required based on an aesthetic or assembly requirement. This is not limited in embodiments of this application. FIG. 4 to FIG. 6 are merely examples, and do not constitute a limitation on embodiments of this application.

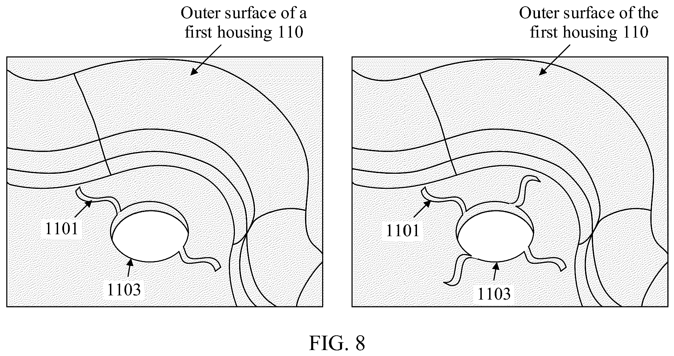

In a possible implementation, the first ventilation channel 1101 and the second ventilation channel 1102 are straight channels or curved channels. For ease of understanding, refer to FIG. 7 and FIG. 8 as an example. In FIG. 7 and FIG. 8, a line type of the first ventilation channel 1101 located on the outer surface of the first housing 110 is used as an example. A line type of the second ventilation channel 1102 located on the inner surface of the first housing 110 is similar, and details are not described one by one. In addition, FIG. 7 and FIG. 8 show an example in which there are two or four first ventilation channels 1101 that communicate with the first through hole 1103. As shown in FIG. 7, the line type of the first ventilation channel 1101 is a straight line. As shown in FIG. 8, the line type of the first ventilation channel 1101 is a curve. It can be understood that a shape of the curved channel shown in FIG. 8 is merely an example. During specific implementation, the curved channel can be in any curved line shape. This is not limited in embodiments of this application.

In a possible implementation, quantities, lengths, or channel line types of the first ventilation channel 1101 and the second ventilation channel 1102 can be determined based on a ventilation rate requirement of the electronic apparatus 100. For example, if the electronic apparatus 100 requires a large ventilation rate, the quantities of the first ventilation channel 1101 and the second ventilation channel 1102 can be increased, or the lengths of the first ventilation channel 1101 and the second ventilation channel 1102 can be extended, or the first ventilation channel 1101 and the second ventilation channel 1102 can be disposed as straight channels. Conversely, if the electronic apparatus 100 requires a small ventilation rate, the quantities of the first ventilation channel 1101 and the second ventilation channel 1102 can be reduced, or the lengths of the first ventilation channel 1101 and the second ventilation channel 1102 can be shortened, or the first ventilation channel 1101 and the second ventilation channel 1102 can be disposed as curved channels. It can be understood that a correspondence between the ventilation rate requirement and quantities, lengths, or channel line types of ventilation channels can be set based on actual application. This is not limited in embodiments of this application.

In a possible implementation, for example, the lengths of the first ventilation channel 1101 and the second ventilation channel 1102 can range from 8 millimeters to 20 millimeters, widths can range from 0.3 millimeters to 1 millimeter, and depths can range from 0.1 millimeters to 0.5 millimeters. It can be understood that the descriptions of sizes of the ventilation channels herein are merely an example, and do not constitute a limitation on embodiments of this application.

In a possible implementation, the first ventilation channel 1101 and the second ventilation channel 1102 can be, for example, grooves or channels with openings only at two ends. This is not limited in embodiments of this application.

In a possible implementation, a quantity of first ventilation channels 1101 that communicate with the first through hole 1103 can be equal or not equal to a quantity of second ventilation channels 1102 that communicate with the first through hole 1103. This is not limited in embodiments of this application.

In a possible implementation, during specific implementation, to facilitate assembly and fastening between the first housing 110 and the second housing 120, the first housing 110 or the second housing 120 has been provided with a corresponding through hole or via. In this case, the through hole or via can be reused as the first through hole 1103. For example, if the first housing 110 and the second housing 120 are fastened through a threaded connection, the first through hole 1103 can be a through hole through which a threaded joint penetrates. For another example, if the first housing 110 and the second housing 120 are fastened through a snap-fit connection, the first through hole 1103 can be a via of a snap-fit. It can be understood that the descriptions herein are merely an example, and do not constitute a limitation on embodiments of this application. For ease of understanding, the following further describes an example in which the first housing 110 and the second housing 120 are fastened through a threaded connection.

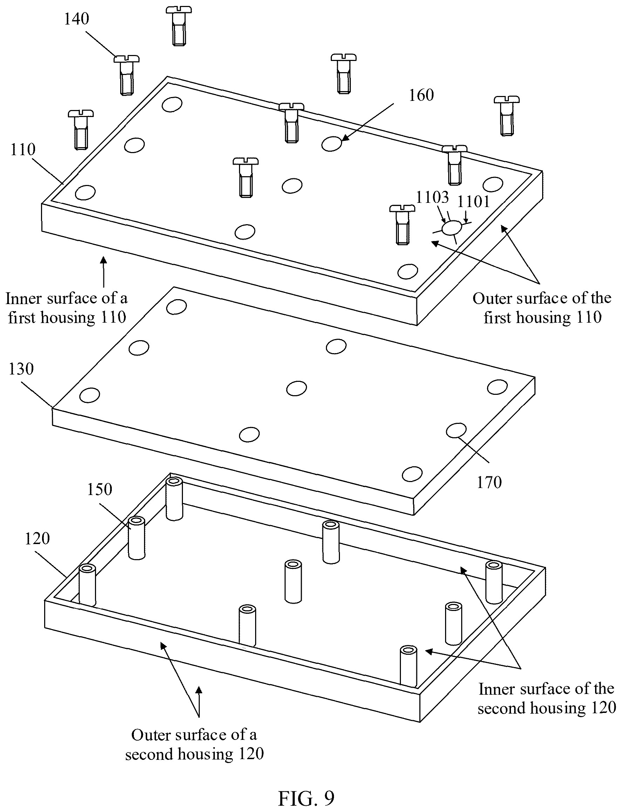

In a possible implementation, if the first housing 110 and the second housing 120 are fastened through a threaded connection, the first through hole 1103 can be a through hole through which a threaded joint penetrates. It can be learned from the foregoing descriptions that the threaded joint can be, for example, a bolt, a stud, or a screw. For ease of understanding, the following uses an example in which the threaded joint is a screw for description. For example, refer to FIG. 9.

FIG. 9 is a diagram further illustrating the exploded structure of the electronic apparatus 100 shown in FIG. 2. It can be learned that the electronic apparatus 100 can further include one or more screws 140. FIG. 9 shows nine screws 140 as an example. For fitting, the first housing 110 is provided with nine through holes 160. In addition, for fitting, the inner surface of the second housing 120 is provided with nine threaded holes 150. The threaded hole 150 is configured to fit the screw 140 to fasten the first housing 110 and the second housing 120.

For example, the nine threaded holes 150 protrude on the inner surface of the second housing 120 to form columns, as shown in FIG. 9. Alternatively, for example, the nine threaded holes 150 can be embedded in the second housing 120, so that an end face of the threaded hole is flush with the inner surface of the second housing 120.

For example, during specific implementation, the screw 140 can penetrate through the through hole 160 on the first housing 110, and then be connected to the threaded hole 150 on the second housing 120. The screw 140 is rotated and tightened, so that the first housing 110 is fastened to the second housing 120.

For example, as shown in FIG. 9, the screw 140 can further penetrate through the intermediate component 130. For fitting, the intermediate component 130 is provided with nine through holes 170. For example, during specific implementation, the screw 140 can penetrate through the through hole 160 on the first housing 110, penetrate through the through hole 170 on the intermediate component 130, and then be connected to the threaded hole 150 on the second housing 120. The screw 140 is rotated and tightened, so that the first housing 110 is fastened to the second housing 120.

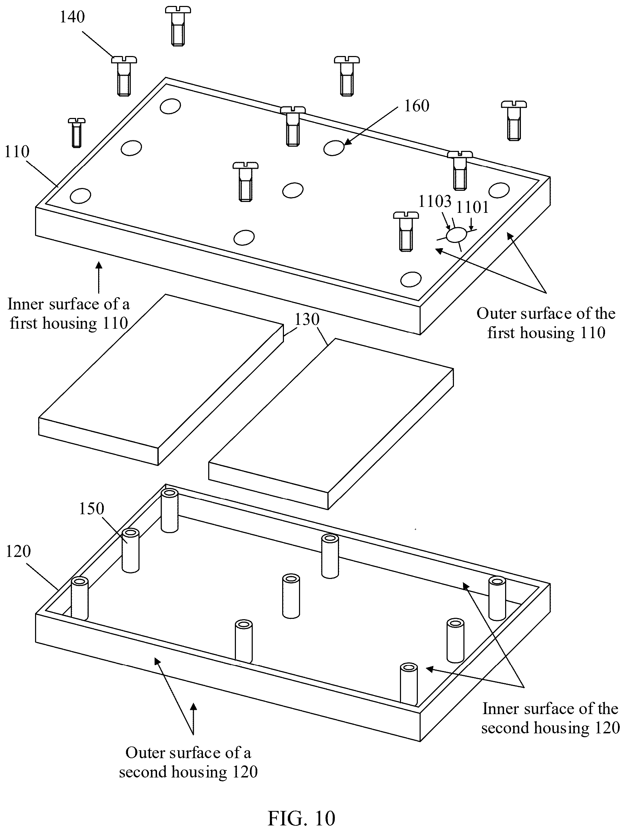

In another possible implementation, the screw 140 may not penetrate through the intermediate component 130. In other words, there is no direct assembly relationship between the intermediate component 130 and the screw 140. For ease of understanding, refer to FIG. 10 as an example. As shown in FIG. 10, after penetrating through the through hole 160 on the first housing 110, the screw 140 can be directly connected to the threaded hole 150 on the second housing 120. The screw 140 is rotated and tightened, so that the first housing 110 is fastened to the second housing 120. The first housing 110 is fastened to the second housing 120, so that the intermediate component 130 can be clamped and fastened. For example, in FIG. 10, the intermediate component 130 includes two subcomponents (for example, two PCB boards). During specific implementation, a quantity of subcomponents included in the intermediate component 130 is not limited in embodiments of this application.

In the implementation shown in FIG. 9 or FIG. 10, one or more of the nine through holes 160 can be the first through hole 1103. A through hole that is used as the first through hole 1103 can communicate with the first ventilation channel 1101 and the second ventilation channel 1102. FIG. 9 or FIG. 10 shows an example in which one of the nine through holes 160 is used as the first through hole 1103. It can be understood that FIG. 9 or FIG. 10 is merely an example. During specific implementation, one or more of the nine through holes 160 can be selected as the first through hole 1103 based on the ventilation rate requirement. This is not limited in embodiments of this application. For example, during specific implementation, the screw 140 has threads, and therefore a gap can be formed between the threads. In addition, there is a gap between the screw 140 and the through hole 160 (and optionally the through hole 170) and the threaded hole 150. In this way, gas can flow in the gaps, and internal and external ventilation and air pressure balance can be maintained through the first ventilation channel 1101 and the second ventilation channel 1102.

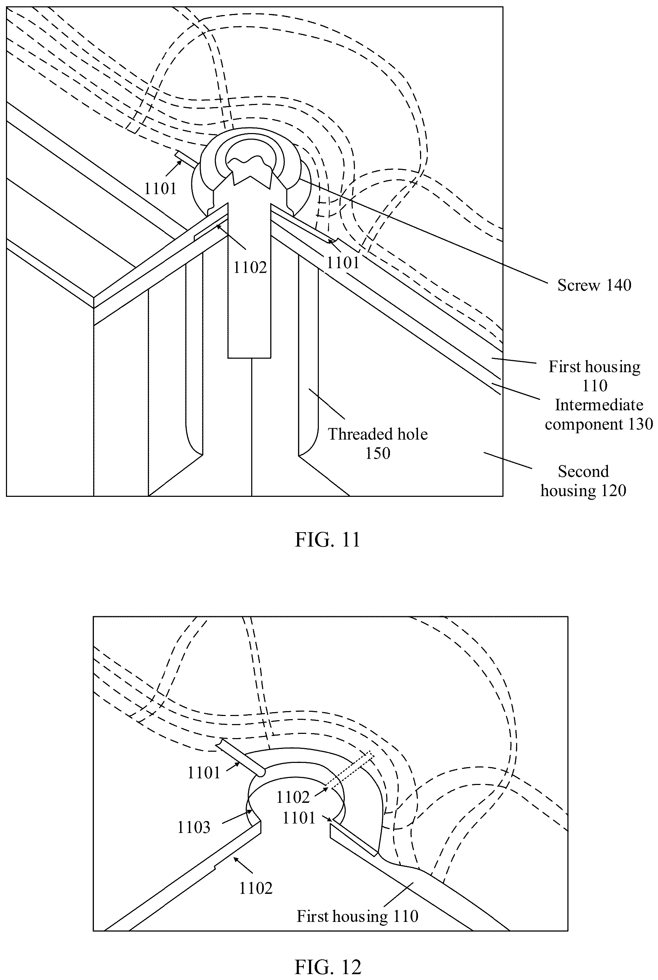

For example, to more intuitively understand disposition of the first ventilation channel 1101 and the second ventilation channel 1102 in the implementation shown in FIG. 9 or FIG. 10, refer to FIG. 11 and FIG. 12. FIG. 11 and FIG. 12 are cross-sectional diagrams of the electronic apparatus 100. FIG. 11 and FIG. 12 each show an example in which there are two first ventilation channels 1101 and two second ventilation channels 1102. As shown in FIG. 11 and FIG. 12, the two first ventilation channels 1101 are disposed on the outer surface of the first housing 110, and the two second ventilation channels 1102 are disposed on the inner surface of the first housing 110. For example, there is an angular deflection between the first ventilation channel 1101 and the second ventilation channel 1102.

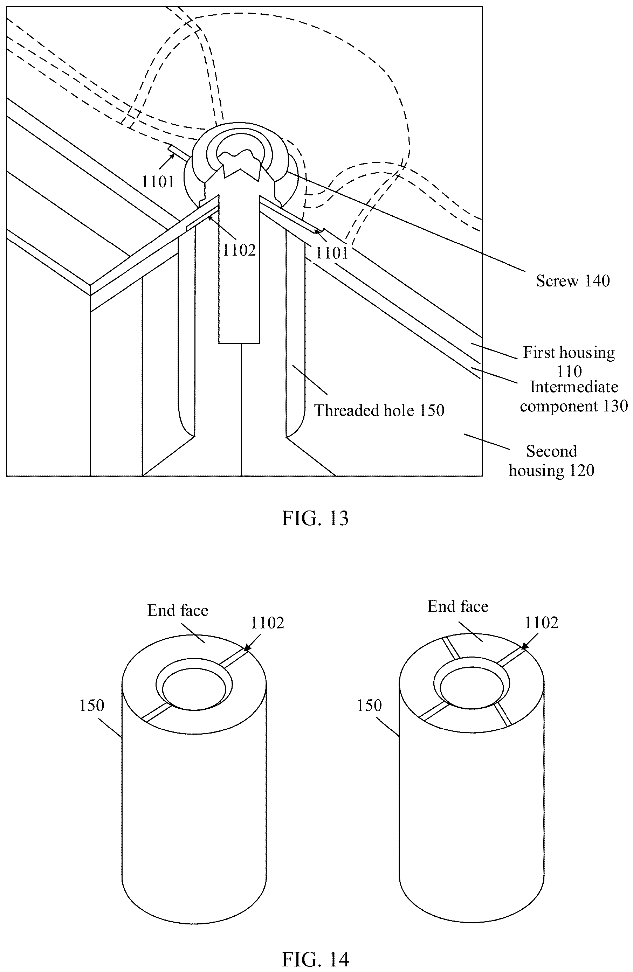

For example, to more intuitively understand the solution shown in FIG. 10 in which there is no direct assembly relationship between the intermediate component 130 and the screw 140, refer to FIG. 13. FIG. 13 is a cross-sectional diagram of the electronic apparatus 100. It can be learned by comparing FIG. 13 and FIG. 11 that the screw 140 is in contact with and connected to the first housing 110 and the second housing 120, and the screw 140 is not in contact with the intermediate component 130. After the screw 140 is tightened to fasten the first housing 110 to the second housing 120, the first housing 110 and the second housing 120 can clamp the intermediate component 130 to fasten the intermediate component 130.

In the foregoing descriptions, an example in which the second ventilation channel 1102 is disposed on the inner surface of the first housing 110 is mainly used for description. In another possible implementation, in the implementation shown in FIG. 9 or FIG. 10, the second ventilation channel 1102 can be disposed on an end face of the threaded hole 150. For ease of understanding, refer to FIG. 14 as an example. FIG. 14 shows an example in which two or four second ventilation channels 1102 are disposed on the end face of the threaded hole 150. During specific implementation, gas can flow in the gap between the threads of the screw 140, and in the gap between the screw 140, the through hole, and the threaded hole, and internal and external ventilation and air pressure balance can be maintained through the first ventilation channel 1101 and the second ventilation channel 1102.

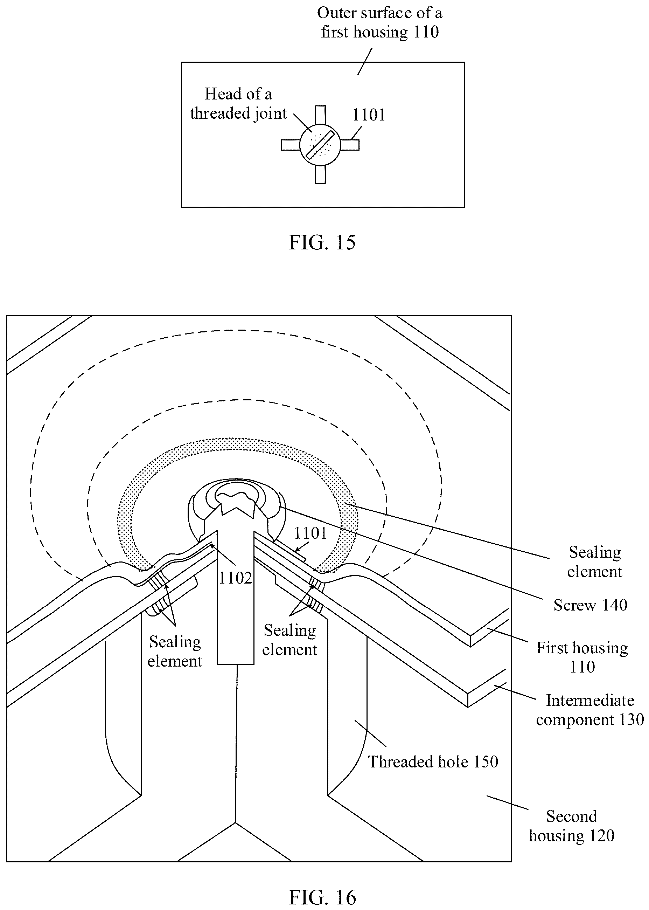

In a possible implementation, the threaded joint can include two parts: a head and a screw rod. For example, refer to the screw 140 shown in FIG. 9 or FIG. 10. To facilitate circulation of internal and external gas, the first ventilation channel 1101 can be disposed to extend beyond an area covered by the head of the threaded joint. For ease of understanding, refer to FIG. 15 as an example. FIG. 15 is a partial top view of the outer surface of the first housing 110 after the first housing 110 is fastened to the second housing 120. It can be learned that the threaded joint penetrates through the first through hole 1103 (covered by the head of the threaded joint) and is embedded in the first housing 110, and the head of the threaded joint covers the outer surface of the first housing 110. The first ventilation channel 1101 (FIG. 15 shows four first ventilation channels 1101 as an example) extends from the first through hole 1103 to the outside of the area covered by the head of the threaded joint.

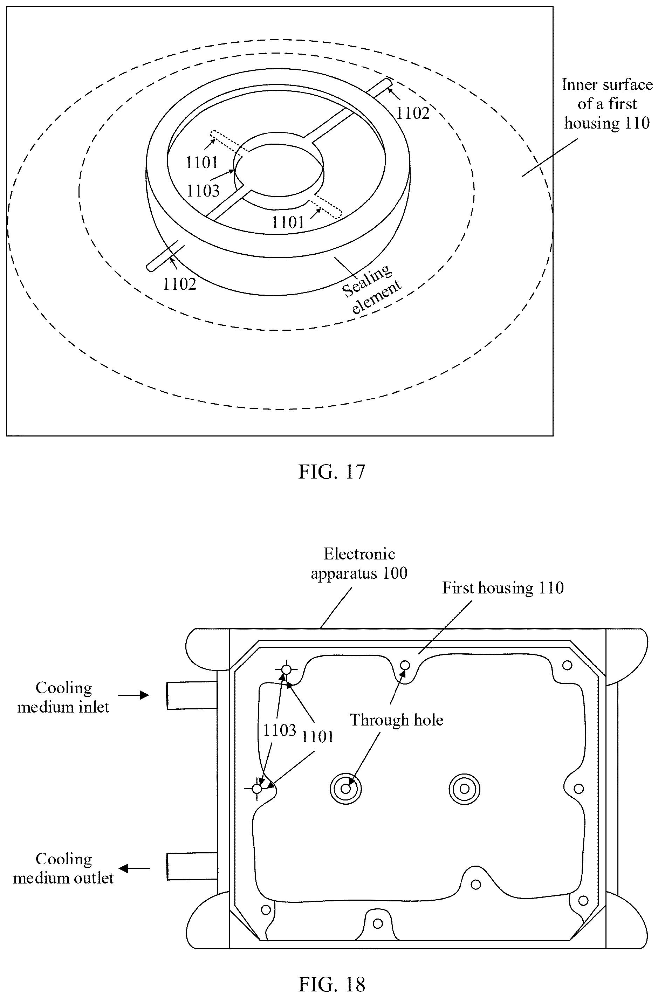

In a possible implementation, in an application scenario with a high sealing requirement, a sealing element can be added around the screw 140. For example, the sealing element can be a sealing ring or a sealing pad. This is not limited in embodiments of this application. For example, the sealing element is disposed between the first housing 110 and the second housing 120, and is disposed around the first through hole 1103, so that the first through hole 1103 is encircled in the middle. In this implementation, the second ventilation channel 1102 can extend beyond a coverage area of the sealing ring, to maintain a controllable ventilation rate. For ease of understanding, refer to FIG. 16 and FIG. 17 as an example.

FIG. 16 shows an example in which there is a direct assembly relationship between the intermediate component 130 and the screw 140. As shown in FIG. 16, in this implementation, two sealing elements can be disposed. One sealing element is disposed between the first housing 110 and the intermediate component 130, and the first through hole 1103, namely, the screw 140, is encircled in the middle. Another sealing element is disposed between the second housing 120 and the intermediate component 130, and similarly, the first through hole 1103, namely, the screw 140, is encircled in the middle. For example, in another implementation, if there is no direct assembly relationship between the intermediate component 130 and the screw 140, one sealing ring can be disposed between the first housing 110 and the second housing 120.

For example, as shown in FIG. 16, the second ventilation channel 1102 extends beyond the coverage area of the sealing element. For more intuitive understanding, refer to FIG. 17 as an example. FIG. 17 is a partial diagram of the inner surface of the first housing 110. For example, in FIG. 17, the sealing element encircles the first through hole 1103 in the middle. The second ventilation channel 1102 extends beyond the coverage area of the sealing ring. For example, the first ventilation channel 1101 can be within the coverage area of the sealing ring, as shown in FIG. 17. Alternatively, for example, the first ventilation channel 1101 can extend beyond the coverage area of the sealing ring. This is not limited in embodiments of this application.

In a possible implementation, the electronic apparatus 100 needs to dissipate heat. For example, the electronic apparatus 100 needs to dissipate heat when the electronic apparatus 100 is a vehicle-mounted controller. For example, the electronic apparatus 100 can dissipate heat through liquid cooling or air cooling. In this case, the electronic apparatus 100 can further include a cooling medium inlet and outlet. In this implementation, a ventilation channel can be disposed at a position close to the cooling medium inlet. Because a temperature at this position is the lowest and condensation beads are most likely to be formed, the ventilation channel can be designed here to quickly dissipate condensation beads. For example, this implementation solution is particularly applicable to a liquid cooling heat dissipation scenario. In the liquid cooling heat dissipation scenario, coolant enters the electronic apparatus 100 that has a high temperature, and condensation or condensation beads are easily generated when the coolant is cooled. If a ventilation amount is large, more external water vapor enters, and more condensation beads are formed. However, in this solution, a ventilation rate of the ventilation channel is controllable, and a large amount of external water vapor is not introduced. In addition, the ventilation channel is disposed close to the cooling medium inlet, so that condensation or condensation beads can be quickly dissipated. For ease of understanding, refer to FIG. 18 as an example.

FIG. 18 illustrates a diagram of an appearance structure of the electronic apparatus 100 viewed from the top of the first housing 110. It can be learned that the electronic apparatus 100 includes a cooling medium inlet and a cooling medium outlet. For example, if heat is dissipated through liquid cooling, the cooling medium inlet is a coolant inlet, and the cooling medium outlet is a coolant outlet. For example, if heat is dissipated through air cooling, the cooling medium inlet is an air intake vent, and the cooling medium outlet is an air outlet vent. It can be understood that the descriptions herein are merely an example, and do not limit a specific heat dissipation manner in embodiments of this application. In addition, it can be further learned from FIG. 18 that the first housing 110 is provided with a plurality of through holes. For example, if the first housing 110 and the second housing 120 of the electronic apparatus 100 are fastened through a threaded connection, screws (for example, the screws 140) further exist in the first through holes 1103 during specific implementation. For example, as shown in FIG. 18, a ventilation channel can be disposed in a through hole close to the cooling medium inlet. The through hole in which the ventilation channel is disposed is the first through hole 1103. In other words, the first through hole 1103 is closer to the cooling medium inlet than a through hole in which no ventilation channel is disposed. FIG. 18 shows the outer surface of the first housing 110. Therefore, the first ventilation channel 1101 is shown.

It can be understood that FIG. 18 is merely an example, and does not constitute a limitation on embodiments of this application.

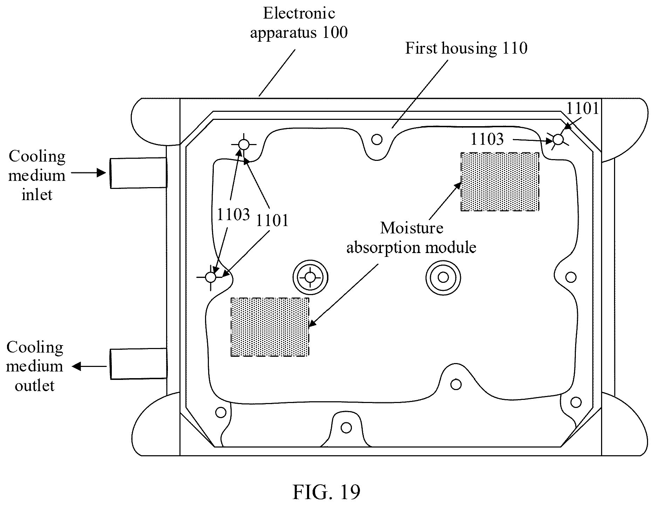

In a possible implementation, a moisture absorption module can be further disposed in the electronic apparatus 100. The moisture absorption module can include, for example, a moisture absorption material like silica gel, activated carbon, bamboo charcoal, or polymer fibers, to absorb water vapor inside the electronic apparatus 100. In this implementation, a ventilation channel can be disposed at a position close to the moisture absorption module. The ventilation channel is disposed here to quickly evaporate the water vapor absorbed by the moisture absorption module. For ease of understanding, refer to FIG. 19 as an example.

For example, FIG. 19 shows two more moisture absorption modules than FIG. 18. The two moisture absorption modules shown in FIG. 19 merely indicate positions of the moisture absorption modules in the electronic apparatus 100. During specific implementation, the moisture absorption modules cannot be seen from the outside. For example, as shown in FIG. 19, a ventilation channel can be disposed in a through hole close to the moisture absorption module. The through hole in which the ventilation channel is disposed is the first through hole 1103. In other words, the first through hole 1103 is closer to the moisture absorption module than a through hole in which no ventilation channel is disposed.

It can be understood that FIG. 18 is merely an example, and does not constitute a limitation on embodiments of this application.

Embodiments of this application further provide a terminal device. The terminal device includes the electronic apparatus 100 in any one of the foregoing possible embodiments. For example, the terminal device can be a transportation means like a vehicle, an unmanned aerial vehicle, or a robot. Certainly, the terminal device can alternatively be replaced with an industrial device, an entertainment device, or the like. This application does not limit a device to which the electronic apparatus 100 is applicable.

In conclusion, according to the electronic apparatus provided in embodiments of this application, a ventilation function of the electronic apparatus can be implemented at low costs while introduction of external water vapor is reduced, balance between internal and external pressure of the electronic apparatus is implemented, and a breathing effect failure of a sealed interface is avoided. The ventilation solution is directly formed on a housing of the electronic apparatus, and has features of no ventilation valve, no ventilation film, no mounting, no inspection, and low costs. In addition, a ventilation rate is controllable by controlling shapes, lengths, and a deflection angle of ventilation channels, and an application scenario is wide.

It should be understood that sequence numbers of processes do not mean execution sequences in embodiments of this application. The execution sequences of the processes should be determined based on functions and internal logic of the processes, and should not constitute any limitation on implementation processes of embodiments of this application.

It should be further understood that the term "include" (also referred to as "includes", "including", "comprises", and/or "comprising"), when being used in this specification, specifies presence of the stated features, integers, steps, operations, elements, and/or components, with presence or addition of one or more other features, integers, steps, operations, elements, components, and/or their combinations not excluded.

It should be further understood that "one embodiment", "an embodiment", and "a possible implementation" mentioned throughout the specification mean that a specific feature, structure, or characteristic related to the embodiment or implementation is included in at least one embodiment of this application. Therefore, "in one embodiment", "in an embodiment", or "in a possible implementation" appearing throughout the specification may not necessarily refer to a same embodiment. In addition, these particular features, structures, or characteristics can be combined in one or more embodiments in any appropriate manner.

Finally, it should be noted that the foregoing embodiments are merely intended for describing the technical solutions of this application other than limiting this application. Although this application is described in detail with reference to the foregoing embodiments, persons of ordinary skill in the art should understand that they can still make modifications to the technical solutions described in the foregoing embodiments or make equivalent replacements to a part of or all technical features thereof, without departing from the scope of the technical solutions of embodiments of this application.

## Claims

1. An electronic apparatus, wherein the electronic apparatus comprises a first housing, an intermediate component, and a second housing, the first housing is fastened to the second housing, and the intermediate component is fastened in a cavity formed by the first housing and the second housing;
the first housing comprises an outer surface and an inner surface, the inner surface is a side surface facing the intermediate component, and the outer surface is another side surface facing away from the inner surface; and
a first ventilation channel is disposed on the outer surface of the first housing, the first housing is provided with a first through hole, a second ventilation channel is disposed in the cavity, and the first through hole communicates with the first ventilation channel and the second ventilation channel.

2. The electronic apparatus according to claim 1, wherein the second ventilation channel is angularly deflected relative to the first ventilation channel.

3. The electronic apparatus according to claim 1 or 2, wherein the first housing and the second housing are capable of being fastened through any one of the following connections: a threaded connection, a snap-fit connection, an adhesive connection, an ultrasonic connection, a solder connection, a hinged connection, or a rivet connection.

4. The electronic apparatus according to any one of claims 1 to 3, wherein if the first housing and the second housing are fastened through a threaded connection, the first through hole is a through hole through which a threaded joint penetrates.

5. The electronic apparatus according to claim 4, wherein the first ventilation channel extends beyond an area covered by a head of the threaded joint.

6. The electronic apparatus according to claim 4 or 5, wherein an inner surface of the second housing is provided with a threaded hole, the threaded hole is configured to fit the threaded joint to fasten the first housing and the second housing, and the inner surface of the second housing is a side surface facing the intermediate component; and the second ventilation channel is disposed on an end face of the threaded hole.

7. The electronic apparatus according to any one of claims 1 to 5, wherein the second ventilation channel is disposed on the inner surface of the first housing.

8. The electronic apparatus according to any one of claims 4 to 6, wherein the intermediate component comprises a second through hole, and the threaded joint penetrates through the second through hole.

9. The electronic apparatus according to claim 7 or 8, wherein the electronic apparatus further comprises a sealing element, the sealing element is disposed between the first housing and the second housing, the first through hole is in the middle of the sealing element, and the second ventilation channel extends beyond a coverage area of the sealing ring.

10. The electronic apparatus according to any one of claims 1 to 9, wherein cross sections of the first ventilation channel and the second ventilation channel are rectangular, triangular, or semicircular.

11. The electronic apparatus according to any one of claims 1 to 10, wherein the first ventilation channel and the second ventilation channel are straight channels or curved channels.

12. The electronic apparatus according to any one of claims 1 to 11, wherein a plurality of first ventilation channels are disposed on the outer surface of the first housing, and a plurality of second ventilation channels are disposed in the cavity.

13. The electronic apparatus according to any one of claims 1 to 12, wherein the electronic apparatus further comprises a cooling medium inlet and a third through hole, the cooling medium is used for dissipating heat for the electronic apparatus, and no ventilation channel that communicates with the third through hole is disposed; and
the first through hole is closer to the cooling medium inlet than the third through hole.

14. The electronic apparatus according to any one of claims 1 to 13, wherein the electronic apparatus further comprises a moisture absorption module and a fourth through hole, the moisture absorption module is configured to absorb water vapor inside the electronic apparatus, and no ventilation channel that communicates with the fourth through hole is disposed; and
the first through hole is closer to the moisture absorption module than the fourth through hole.

15. The electronic apparatus according to any one of claims 1 to 14, wherein the electronic apparatus is an autonomous driving controller, a cockpit domain controller, a vehicle control unit, or a vehicle integrated/integration unit in a vehicle.

16. A terminal device, wherein the terminal device comprises the electronic apparatus according to any one of claims 1 to 15.
